# EUROPEAN PATENT SPECIFICATION

(11) **EP 0 655 356 B1**
(45) Date of publication and mention of the grant of the patent: **02.10.1996**
(21) Application number: 94306738.9
(22) Date of filing: 14.09.1994
(51) Int. Cl.: B60G 17/015, B60G 17/08

(54) **Control system for variable rate dampers**
Regelungssystem für regelbare Stossdämpfer
Système de réglage pour amortisseurs réglables

(30) Priority: 22.11.1993 GB 9323988
(43) Date of publication of application: 31.05.1995
(73) Proprietor: FORD MOTOR COMPANY LIMITED, Brentwood Essex (GB); Ford-Werke Aktiengesellschaft, 50725 Köln (DE); FORD FRANCE S. A., 92506 Rueil-Malmaison Cédex (FR)
(72) Inventor: Bramley, Duncan, Bulpham, Upminster, Essex (GB)
(74) Representative: Messulam, Alec Moses

(56) References cited:
- EP-A- 0 075 657
- FR-A- 2 588 343
- PATENT ABSTRACTS OF JAPAN vol. 17, no. 18 (M-1352) 13 January 1993 & JP-A-04 244 631 (KURASHIKI KAKO) 1 September 1992
- PATENT ABSTRACTS OF JAPAN vol. 14, no. 373 (M-4316) 13 August 1990 & JP-A-02 134 432 (TOYOTA) 23 May 1990
- PATENT ABSTRACTS OF JAPAN vol. 14, no. 237 (M-0976) 21 May 1990 & JP-A-02 062 465 (MAZDA) 2 March 1990
- PATENT ABSTRACTS OF JAPAN vol. 15, no. 234 (P-1215) 14 June 1991 & JP-A-03 071 302 (TOYOTA) 27 March 1991

## Description

The present invention relates to a motor vehicle having variable rate dampers and a control system for applying pulse width modulated (PWM) control signals to the dampers.

The ride of a motor vehicle is strongly affected by the rate of the dampers and adaptive damping systems have been proposed in which the damping rate may be varied with driving conditions. Dampers are known with a solenoid operated valve in their hydraulic circuit, both on/off and continuously variable solenoid valves having been previously proposed.

Though continuously variable solenoid valves can be controlled by means of analogue signals, it is preferred in some systems such as the system disclosed in FR-A-2588343 to use digital pulse width modulation to regulate the mean current flowing through the solenoid. However, it has been found that such control gives rise to serious problems on account of electrical noise that can affect other electrical equipment in the vehicle.

The object of the present invention is to reduce the electrical noise generated when controlling the variable rate dampers using pulse width modulated signals.

According to the present invention, there is provided a motor vehicle having variable rate dampers and a control system for applying pulse width modulated (PWM) control signals to the dampers, the control signals applied to the dampers having a constant frequency and a variable mark to space ratio, characterised in that the control signals applied by the control system to the different dampers are out of phase with one another so as to reduce the ripple component of the sum of the currents drawn from the vehicle power supply.

Conventionally, all the dampers are controlled in phase so that periods in which current is drawn by all electrical elements are followed by periods of no current being drawn by any of the elements. By phase shifting the control signals of the dampers relative to one another, the present invention balances the electrical load more evenly in that the current drawn by the different dampers will be staggered within each cycle thereby reducing the ripple or a.c. component. Any fluctuating current can be regarded as an a.c. current superimposed on a d.c. offset and in the present invention, the amplitude of the a.c. component is reduced, when compared to a system in which all elements are operated in phase with one another.

It will be appreciated that there are two sources of electrical noise, one resulting from conduction and the other from radiation. In the vehicle environment, it is the conductive noise that is the more serious and this results from the current that is returned to ground by the individual dampers when they are switched on. The staggering of these currents reduces this noise.

A further advantage of the invention is that the frequency of the ripple component will also be increased by a factor equal to the number of different dampers and different phases used. As frequency is increased, filtering may be performed more simply using smaller and less expensive electrical components (inductors and capacitors).

In the control of four dampers in a motor vehicle, it is preferred to use control signals in phase quadrature with one another, in which case the ripple frequency will be increased by a factor of four. Thus, if each solenoid is turned on and off with a frequency around 250 Hz, the frequency of the ripple component will be 1000 Hz.

The phase between two repetitive signals of differing pulse width can be measured from different reference points. In the present invention, the phase is preferably measured from the centres of the current pulses but it is also possible to measure the phase from the leading edges of the pulses.

The invention will now be described further, by way of example, with reference to the accompanying drawings, in which:
Figure 1 is a circuit diagram of a circuit generating four symmetrical saw tooth waveforms in phase quadrature with one another, and
Figure 2 is an output stage for driving a solenoid operated valve of a hydraulic damper in an adaptive damping system in a motor vehicle.

The illustrated control system is for supplying pulse width modulated signals to four electrically controlled dampers of a vehicle. The rate of the dampers is determined by the mean current applied to the dampers and instead of applying a varying analogue signal to the dampers, the control system applies pulse width modulated signals. There are two advantages to be gained by such control. First, there is lower power consumption and second the valve that is controlled by the signal is subjected to a constant vibration which avoids so-called stiction. Because the coefficient of static friction is greater than the coefficient of dynamic friction, by keeping the valve in permanent motion it is possible to achieve smoother and more accurate control. For this effect to be achieved, the frequency of vibration is important. It has been found experimentally for the dampers with which the invention has been tested that the frequency should be between 100 and 400 Hz, preferably between 220 and 300 Hz, 260 Hz being the ideal control frequency.

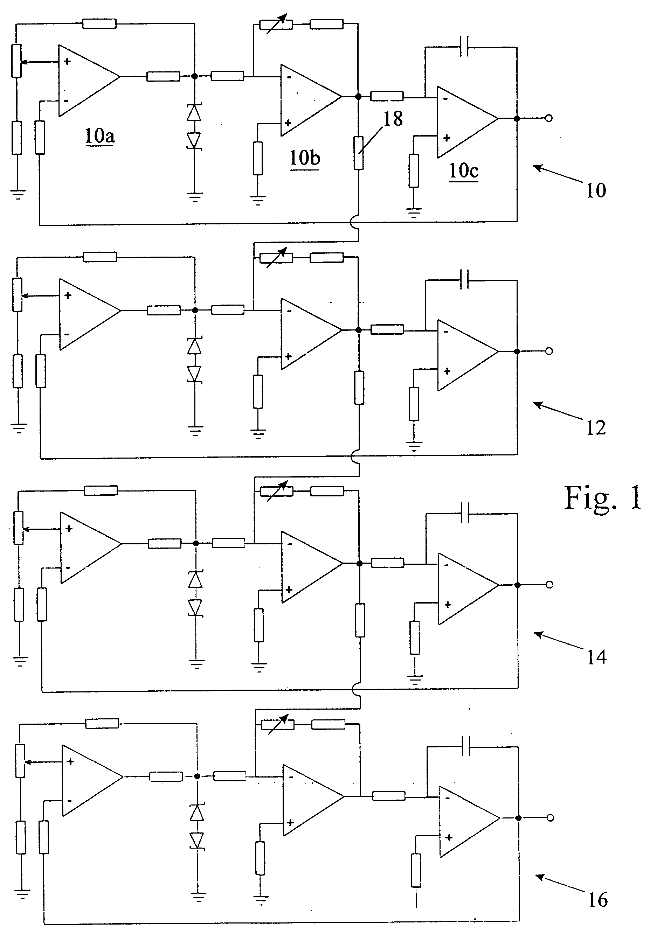

Figure 1 shows four identical saw tooth oscillators 10, 12, 14, 16 that are phase locked to one another. The oscillator 10, comprises a comparator 10a, an inverter 10b and an integrator 10c. The output of the inverter 10b can adopt one of only two states (ON/OFF). While ON, its output is integrated by the integrator 10c giving rise to a rising ramp. When the output voltage of the integrator 10c reaches an upper threshold, the comparator changes states and in turn switches the inverter 10b OFF. The output of the integrator 10c now follows a falling ramp until the a lower threshold is reached and once again the comparator 10a and the inverter 10b change states, thereby generating the desired symmetrical saw tooth waveform. The gain of the inverter 10b sets the steepness of the ramp and therefore the frequency of oscillation.

Each of the oscillators 12, 14 and 16 is weakly coupled to the oscillator above it by means of a resistor 18 leading from the output of the upper inverter to the input of the lower inverter, as drawn. This coupling locks the phase of the pairs of oscillators so that they run 90° out of phase with one another.

It should be mentioned that the above description is only of one example of how to generate reference signals in phase quadrature. There are numerous alternatives, one of which would be to derive all the signals by dividing the output of a single oscillator. Signals in anti-phase can also be generated simply by inversion.

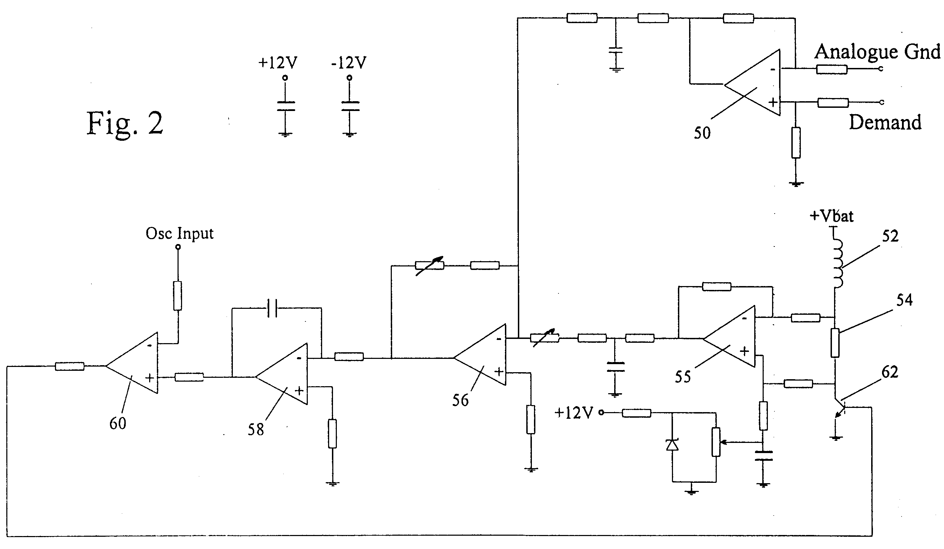

In Figure 2, a demand signal setting the desired hardness of a damper, which signal may for example be generated by an on-board computer, is supplied to an input amplifier and inverter 50. The actual position of the damper valve is derived from the mean current flowing through the solenoid 52. This current is measured by sensing the voltage across a series resistor 54, the ends of which are connected across the inputs of an amplifier 55. The output of the amplifier 55 is smoothed and summed with the inverted demand signal to produce an error signal at the output of an amplifier 56.

The error signal is integrated in an integrator 58 to produce a d.c. signal that is compared in an operational amplifier 60 with the saw tooth waveform generated by one of the channels of the oscillator described by reference to Figure 1. For as long as the saw tooth waveform exceeds the integrated error signal the drive transistor 62 of the solenoid 52 is switched on. Thus as the integrated error signal increases, the mark to space ratio is reduced thereby moving the solenoid in the correct direction to reduce the error signal and closing the feedback control loop.

Because of the symmetry of the saw tooth waveform, the pulses for operating the solenoid 52 are always symmetrical about the peaks of the sawtooth waveform and the pulses applied to different solenoids will also therefore be in phase quadrature when measured from the centre line of pulses.

Though the invention has been described by reference to hydraulic dampers, it should be clear that the noise reduction advantage offered by the invention will be achieved in a vehicle using any form of damper in which the rate is electrically controlled using a pulse width modulated signal.

## Claims

1. A motor vehicle having variable rate dampers and a control system for applying electrical pulse width modulated (PWM) control signals to the dampers, the control signals applied to the dampers having a constant frequency and a variable mark to space ratio, characterised in that the control signals applied by the control system to the different dampers are out of phase with one another so as to reduce the ripple component of the sum of the currents drawn from the vehicle power supply.

2. A motor vehicle as claimed in claim 1 having four variable rate dampers, characterised in that the control signals applied to the four dampers are in phase quadrature with one another.

3. A motor vehicle as claimed in claim 2, wherein the control signal applied to the dampers have a frequency in the range from 100 Hz to 400 Hz, and preferably lies between 220 Hz and 300 Hz.

## Patentansprüche

1. Ein Kraftfahrzeug mit Dämpfern variabeler Stärke und einem Regelsystem zur Anwendung elektrischer Regelsignale mit modulierter Impulsbreite (PWM) auf die Dämpfer, wobei die auf die Dämpfer ausgeübten Regelsignale eine konstante Frequenz und ein variabeles Markierungs/Abstands Verhältnis haben, dadurch gekennzeichnet, dass die Regelsignale, die vom Regelsystem auf die verschiedenen Dämpfer ausgeübt werden, miteinander ausserphasig sind, um die Welligkeitskomponente der Summe des Stroms, der von der Energiezufuhr des Fahrzeugs bezogen wird, zu reduzieren.

2. Ein Kraftfahrzeug nach Anspruch 1, mit vier Dämpfern mit variabeler Stärke, dadurch gekennzeichnet, dass sich die Regelsignale, die auf die vier Dämpfer einwirken, miteinander in einer Phasenverschiebung um 90° befinden.

3. Ein Kraftfahrzeug nach Anspruch 2, in dem das auf die Dämpfer ausgeübte Regelsignal eine Frequenz im Bereich von 100 Hz bis zu 400 Hz hat und die vorzugsweise zwischen 220 Hz und 300 Hz liegt.

## Revendications

1. Véhicule à moteur comportant des amortisseurs à taux variable et un système de commande destiné à appliquer aux amortisseurs des signaux de commande modulés par largeur d'impulsion électrique (PWM), les signaux de commande appliqués aux amortisseurs présentant une fréquence constante et un rapport cyclique variable, caractérisé en ce que les signaux de commande appliqués par le système de commande aux différents amortisseurs sont déphasés les uns par rapport aux autres de façon à réduire la composante d'ondulation de la somme des courants extraits de l'alimentation électrique du véhicule.

2. Véhicule à moteur selon la revendication 1 comportant quatre amortisseurs à taux variable, caractérisé en ce que les signaux de commande appliqués aux quatre amortisseurs sont en quadrature de phase les uns par rapport aux les autres.

3. Véhicule à moteur selon la revendication 2, dans lequel le signal de commande appliqué aux amortisseurs présente une fréquence dans la plage de 100 Hz à 400 Hz, et qui est située de préférence entre 220 Hz et 300 Hz.
